(19) Europäisches Patentamt
European Patent Office
Office européen des brevets

(11) **EP 4 611 248 A1**

(12) **EUROPEAN PATENT APPLICATION**
published in accordance with Art. 153(4) EPC

(43) Date of publication:
**03.09.2025 Bulletin 2025/36**

(21) Application number: 23882380.1

(22) Date of filing: 06.10.2023

(51) International Patent Classification (IPC):
*H02N 2/04* (2006.01)   *G02B 7/04* (2021.01)
*H10N 30/20* (2023.01)   *H10N 30/853* (2023.01)
*H10N 30/87* (2023.01)

(52) Cooperative Patent Classification (CPC):
G02B 7/04; H02N 2/04; H10N 30/20; H10N 30/853;
H10N 30/87

(86) International application number:
**PCT/JP2023/036462**

(87) International publication number:
**WO 2024/090171 (02.05.2024 Gazette 2024/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 24.10.2022 JP 2022170049

(71) Applicant: CANON KABUSHIKI KAISHA
Tokyo 146-8501 (JP)

(72) Inventors:
• WATANABE, Takayuki
  Tokyo 146-8501 (JP)
• UEBAYASHI, Akira
  Tokyo 146-8501 (JP)

(74) Representative: **Canon Europe Limited
European Intellectual Property Group
4 Roundwood Avenue
Stockley Park
Uxbridge UB11 1AF (GB)**

(54) **VIBRATION ACTUATOR, OPTICAL DEVICE, AND ELECTRONIC DEVICE**

(57)    Provided is a vibration-type actuator in which electric contact between a piezoelectric element and an elastic member is sufficiently ensured. In the vibration-type actuator solving the above-described issue, a plate-like piezoelectric material included in the piezoelectric element has a through-hole penetrating in a thickness direction of the piezoelectric material and includes a through-hole electrode filling the through-hole, the through-hole electrode has a protruding portion protruding from a first opening portion of the through-hole that opens on an elastic member side, a ground electrode electrically connected to the through-hole electrode is provided on a surface on the first opening portion side of the piezoelectric material, and the through-hole electrode and the elastic member are electrically connected.

**FIG.2B**

205   206 ELASTIC MEMBER
204 GROUND ELECTRODE
202 PIEZOELECTRIC MATERIAL
203

## Description

Technical Field

The present invention relates to a vibration-type actuator including an ultrasonic motor.

Background Art

A vibration-type actuator includes a vibrator configured to excite vibration in an elastic member bonded to a piezoelectric element by applying an alternating voltage to an electro-mechanical energy conversion element such as a piezoelectric element. The vibration-type actuator is used as an ultrasonic motor that relatively moves a contact member brought into pressure contact with the vibrator and the vibrator using drive force of the vibration excited in the vibrator.
Patent Literature 1 discusses a method for manufacturing a vibrator used in a vibration-type actuator. In an example of Patent Literature 1, a process of bonding an elastic member (described as a vibration plate in Patent Literature 1) and a power feeding member to a piezoelectric element, grounding the elastic member, and performing polarization processing on a piezoceramics is discussed. However, in the vibrator manufactured using the method for manufacturing a vibrator discussed in Patent Literature 1, due to insufficient electric contact between the piezoelectric element and the elastic member, polarization failure sometimes occurs, and further improvement in yield ratio of the vibration-type actuator has been demanded.

Citation List

Patent Literature

Patent Literature 1: Japanese Patent Application Laid-Open No. 2017-184233

Summary of Invention

Technical Problem

The invention of the present application provides a vibration-type actuator in which electric contact between a piezoelectric element and an elastic member is sufficiently ensured.

Solution to Problem

A vibration-type actuator that solves the above-described issue includes a vibrating member including a conductive elastic member and a piezoelectric element, a contact member configured to come into contact with the elastic member, the vibrating member and the contact member relatively moving due to vibration of the vibrating member, wherein a plate-like piezoelectric material included in the piezoelectric element has a through-hole penetrating in a thickness direction of the piezoelectric material and includes a through-hole electrode filling the through-hole, wherein the through-hole electrode has a protruding portion protruding from a first opening portion of the through-hole that opens on an elastic member side, wherein a ground electrode electrically connected to the through-hole electrode is provided on a surface on the first opening portion side of the piezoelectric material, and wherein the through-hole electrode and the elastic member are electrically connected.

Advantageous Effects of Invention

According to the present invention, it is possible to provide a vibration-type actuator in which electric contact between a piezoelectric element and an elastic member is sufficiently ensured. As a result, a yield of the vibration-type actuator can be further improved.

Brief Description of Drawings

[Fig. 1A] Fig. 1A is a side view illustrating an outline structure of a vibration-type actuator of the present invention that uses an annular piezoelectric material or a rectangular piezoelectric material.
[Fig. 1B] Fig. 1B is a perspective view illustrating the outline structure of the vibration-type actuator of the present invention that uses the annular piezoelectric material or the rectangular piezoelectric material.

[Fig. 1C] Fig. 1C is a rear view illustrating the outline structure of the vibration-type actuator of the present invention that uses the annular piezoelectric material or the rectangular piezoelectric material.

[Fig. 1D] Fig. 1D is a side view illustrating the outline structure of the vibration-type actuator of the present invention that uses the annular piezoelectric material or the rectangular piezoelectric material.

[Fig. 1E] Fig. 1E is a perspective view illustrating the outline structure of the vibration-type actuator of the present invention that uses the annular piezoelectric material or the rectangular piezoelectric material.

[Fig. 1F] Fig. 1F is a rear view illustrating the outline structure of the vibration-type actuator of the present invention that uses the annular piezoelectric material or the rectangular piezoelectric material.

[Fig. 2A] Fig. 2A is a diagram illustrating a cross-section structure near a through-hole of a piezoelectric material before lapping processing.

[Fig. 2B] Fig. 2B is a diagram illustrating the cross-section structure near the through-hole of the piezoelectric material after elastic member bonding (ground electrode thickness < protruding amount).

[Fig. 2C] Fig. 2C is a diagram illustrating the cross-section structure near the through-hole of the piezoelectric material after elastic member bonding (ground electrode thickness > protruding amount).

[Fig. 2D] Fig. 2D is a diagram illustrating a comparative example illustrating a cross-section structure near the through-hole of the piezoelectric material.

[Fig. 3A] Fig. 3A is a diagram illustrating a power feeding member bonded surface, and illustrating an outline structure of an annular piezoelectric element.

[Fig. 3B] Fig. 3B is a diagram illustrating an elastic member bonded surface, and illustrating the outline structure of the annular piezoelectric element.

[Fig. 4A] Fig. 4A is a diagram illustrating a power feeding member bonded surface, and illustrating an outline structure of a rectangular piezoelectric element.

[Fig. 4B] Fig. 4B is a diagram illustrating an elastic member bonded surface, and illustrating the outline structure of the rectangular piezoelectric element.

[Fig. 4C] Fig. 4C is a diagram illustrating the power feeding member bonded surface, and illustrating the outline structure of the rectangular piezoelectric element.

[Fig. 4D] Fig. 4D is a diagram illustrating the elastic member bonded surface, and illustrating the outline structure of the rectangular piezoelectric element.

[Fig. 5A] Fig. 5A is a diagram illustrating two vibration modes (mode A) generated by a vibrator of the present invention that includes a rectangular piezoelectric material.

[Fig. 5B] Fig. 5B is a diagram illustrating the two vibration modes (mode B) generated by the vibrator of the present invention that includes the rectangular piezoelectric material.

[Fig. 6] Fig. 6 is a diagram illustrating an outline structure of an optical device of the present invention.

Description of Embodiments

A vibration-type actuator of the present invention includes a vibrating member including a conductive elastic member and a piezoelectric element provided on the elastic member, and a contact member that comes into contact with the elastic member, and the vibrating member and the contact member move relative to each other due to vibration of the vibrating member. A plate-like piezoelectric material included in the piezoelectric element has a through-hole penetrating in a thickness direction of the piezoelectric material, and includes a through-hole electrode filling the through-hole. The through-hole electrode has a protruding portion protruding from a first opening portion of the through-hole, and a ground electrode electrically connected with the through-hole is provided on a surface on the first opening portion side of the piezoelectric material. In addition, the through-hole electrode and the elastic member are electrically connected.

(Vibration-Type Actuator)

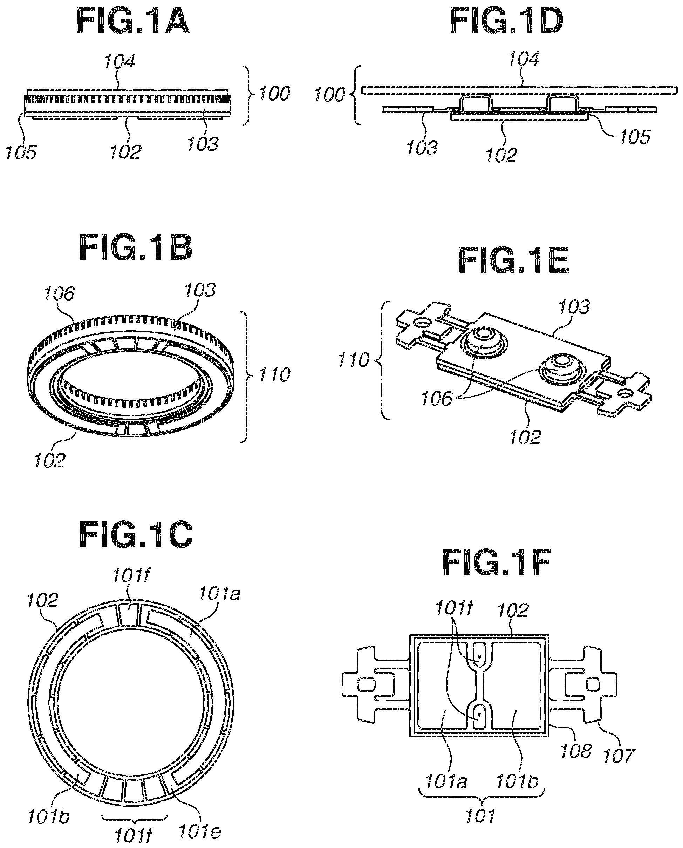

Figs. 1A to 1F exemplify an outline structure of a vibration-type actuator of the present invention.

In the vibration-type actuator exemplified in Figs. 1A to 1F, an annular piezoelectric material and a rectangular piezoelectric material are used. A vibration-type actuator 100 of the present invention includes a vibrator 102 in which an electrode 101, a piezoelectric material 102, and an elastic member 103 are arranged in order, and a contact member 104 that comes into contact with the elastic member 103. The elastic member 103 and the piezoelectric material 102 are bonded via a bonding portion 105.

The elastic member 103 has a projection portion 106, and the projection portion 106 and the contact member 104 are configured to be brought into pressure contact. The contact member 104 may be a member that is movable relative to the vibrator 110, and is not limited to a member that comes into direct contact with the vibrator 110 and may be a member that comes into indirect contact with the vibrator 110 via another member. That is, the "contact member" refers to a member that comes into contact with a vibrating member and moves relative to the vibrating member due to vibration generated in the vibrating member. The contact between the contact member and the vibrating member is not limited to direct contact in which no other member is interposed between the contact member and the vibrating member. As long as the contact member moves relative to a vibrating member due to vibration generated in the vibrating member, the contact between the contact member and the vibrating member may be indirect contact in which another member is interposed between the contact member and the vibrating member. "Another member" is not limited to a member (e.g., high friction material containing a sintered body) independent of the contact member and the vibrating member. "Another member" may be a surface-treated portion formed by plating or nitriding processing on the contact member or the vibrating member.

(Piezoelectric Element)

The piezoelectric material 102 included in the piezoelectric element includes piezoceramics (sintered body) not having crystalline orientation, crystalline-oriented ceramics, and piezoelectric single crystals. The thickness of the piezoelectric material is processed so as to have a design value that falls within a range of approximately 0.3 to 0.5 mm.

In the piezoelectric material 102, at least one through-hole penetrating in the thickness direction and a through-hole electrode filling the through-hole are provided. With a view to generating symmetric vibration, through-holes can be symmetrically arranged in the piezoelectric material, or a configuration in which only one through-hole is provided for one ground electrode may be employed in order to reduce the manufacturing cost of the element.

To suppress disturbance of the vibration in the piezoelectric element and simultaneously obtain sufficient conductivity, the diameter of the through-hole is desirably in a range from 50 to 200 microns.

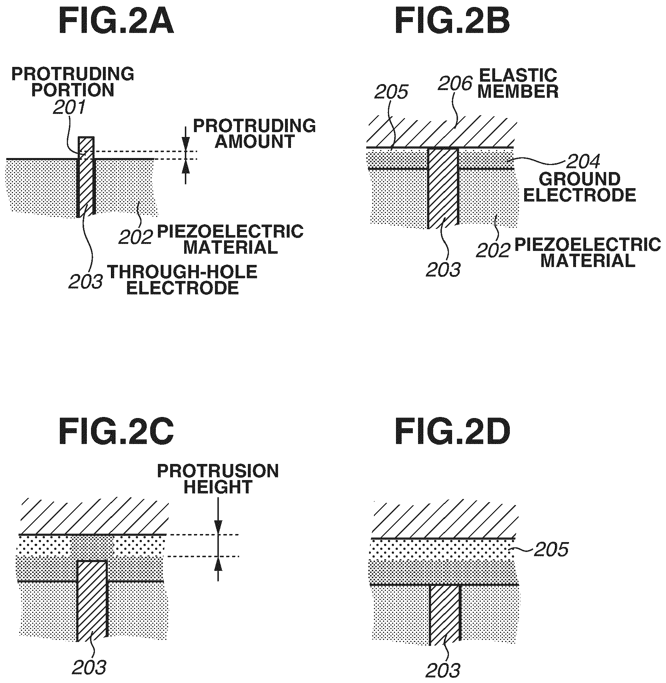

Figs. 2A to 2D exemplify an outline structure of a cross-section of the through-hole provided in the piezoelectric material that is desirable for the vibration-type actuator of the present invention. With a view to planarization of the surface of the piezoelectric element and adjustment of the thickness (protruding amount or height) of a protruding portion of the through-hole electrode, lapping processing is performed on the surface of the piezoelectric material in which the through-hole electrode is provided. After the lapping processing, the protruding portion of the through-hole electrode is formed in the first opening portion opening on an elastic member side of the through-hole.

Because the protruding amount of the protruding portion, i.e., a height from the surface of the piezoelectric material to a tip of the through-hole electrode, varies depending on a grit size of a medium (e.g., silicon carbide) used in the lapping processing, the protruding amount can be adjusted based on the grit size of the medium. For example, as the grit size of the medium becomes larger, the protruding amount becomes smaller. Fig. 2A illustrates a state in which a through-hole electrode 203 filling a through-hole provided in a piezoelectric material 202 protrudes from a first opening portion opening on an elastic member side of a piezoelectric element, and the lapping processing is performed in such a manner that the through-hole electrode 203 protrudes by an amount corresponding to a thickness sandwiched by broken lines. Fig. 2A illustrates a state before the lapping processing is performed, with a height direction exaggerated to illustrate the protrusion of the through-hole electrode. A portion of the through-hole electrode 203 above an upper broken line of the two broken lines is removed by the lapping processing.

A protruding amount of a protruding portion 201 of the through-hole electrode 203, which is sandwiched by the broken lines, is desirably 0.5 microns or more and less than 10 microns. When the protruding portion 201 protrudes by 10 microns or less as the protruding amount, the thickness of a bonding layer can be set to 10 microns or less, and vibration efficiency of the vibration-type actuator can be maintained in a sufficiently satisfactory state. On the other hand, when the protruding amount is 10 microns or more, because the thickness of the bonding layer is larger than 10 microns, the vibration efficiency of the vibration-type actuator may be significantly reduced. Furthermore, the inclination of the elastic member with respect to the surface of the piezoelectric material increases, and a moving speed of the contact member may vary depending on a traveling direction.

The protruding amount is further desirably 5 microns or less. This is because, when the protruding amount is 5 microns or less, the thickness of the bonding layer becomes thinner than 5 microns, and the vibration efficiency of the vibration-type actuator can be maintained in a more satisfactory state.

In addition to inexpensive silver, silver palladium and platinum can be used for the through-hole electrode. In a case where the piezoelectric material and the through-hole electrode are co-fired, a through-hole electrode material is not to be melted during a firing process of the piezoelectric material. Thus, the through-hole electrode material is selected depending on a firing temperature of the piezoelectric material, and in a case where the firing temperature exceeds 1300°C, an electrode material containing platinum as a main component is used. The main component refers to a weight percent concentration of 90% or more. A through-hole electrode can also be formed in a through-hole after the piezoelectric material is fired.

Fig. 2B is an enlarged cross-sectional view illustrating a state after the through-hole provided in the piezoelectric material is filled with the through-hole electrode 203, lapping processing is performed thereon, a ground electrode 204 is formed, and an elastic member 206 and the piezoelectric element are bonded via a bonding layer 205.

The ground electrode 204 provided after the lapping processing and the through-hole electrode 203 come into contact on the surface on the first opening portion side of the piezoelectric material and are electrically connected with each other. Fig. 2B illustrates a case where the thickness of the ground electrode 204 is smaller than the protruding amount of the through-hole electrode 203, and the through-hole electrode 203 comes into contact with the elastic member 206, and they are electrically connected to each other. By pressing the elastic member 206 and the piezoelectric material 202 via the bonding layer 205 applied on the surface of the ground electrode 204 provided on the piezoelectric material 202, a material constituting the bonding layer seeps out from between the ground electrode 204 and the elastic member 206, and is removed. The protruding portion of the through-hole electrode and the elastic member accordingly come into direct contact and are electrically connected with each other.

In a case where the thickness of the ground electrode is sufficiently larger than the protruding amount, the through-hole electrode 203 is covered with the ground electrode, and the ground electrode forms a protrusion portion on the protruding portion. In the present exemplary embodiment, as illustrated in Fig. 2C, the configuration may be such that the protrusion portion of the ground electrode comes into contact with the elastic member, and the ground electrode is electrically connected with the elastic member. The protruding amount of the through-hole electrode may be substituted by a height of the protrusion portion of the ground electrode. Note that the through-hole electrode being covered with the ground electrode can be confirmed by detecting a constituent element of the ground electrode between a top portion of the protruding portion of the through-hole electrode and the elastic member 206.

The elastic member 103 and the piezoelectric material 102 are bonded via the bonding layer 205. The type of adhesive agent is not specifically limited, but an epoxy resin excellent in strength, with a short curing time, and also stable under a high-temperature and high-humidity atmosphere is desirable. A general epoxy resin is insulative.

In a case where the piezoelectric element does not include the protruding portion, when a pressing force in bonding the ground electrode and the elastic member is increased with a view to electrically connecting the ground electrode and the elastic member, the thickness of the bonding layer becomes significantly thin, and the bonding layer partially disappears. Consequently, bonding strength of the elastic member and the piezoelectric element decreases, and a peel-off occurs during the operation of the vibration-type actuator, causing operation failure. On the other hand, unlike in the present exemplary embodiment, when the bonding layer is provided between the elastic member and the ground electrode without providing the protruding portion of the through-hole electrode, the elastic member and the ground electrode are not electrically connected (Fig. 2D). Consequently, operation failure occurs in the vibration-type actuator due to polarization failure, and a yield ratio may decrease.

In the periphery of the above-described protruding portion of the through-hole electrode 203, a void is provided between the ground electrode and the elastic member in accordance with the protruding amount. The void serves as a space for holding an adhesive material containing an insulating material, and by the bonding layer being formed, it is possible to increase bonding strength of the piezoelectric element and the elastic member. By the through-hole electrode having the protruding portion, it is possible to obtain electric connection between the ground electrode and the elastic member without sacrificing the bonding strength of the piezoelectric element and the elastic member.

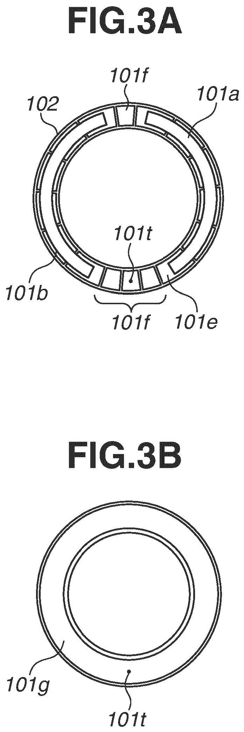

An overview of an annular piezoelectric element that uses an annular piezoelectric material will be specifically described below with reference to Figs. 3A and 3B. In the case of using the annular piezoelectric material, a piezoelectric material includes a drive phase electrode 101e and a non-drive phase electrode 101f that are divided in a circumferential direction (Fig. 3A). The length in the circumferential direction of the drive phase electrode is 1/2 of a wavelength $\lambda$ of a drive frequency. The length in the circumferential direction of the non-drive phase electrode is 1/4 of the wavelength $\lambda$ of the drive frequency. The numbers of drive phase electrodes and non-drive phase electrodes change in accordance with the number of traveling waves excited in the annular piezoelectric material. A piezoelectric material corresponding to each drive phase electrode is subjected to polarization processing with a voltage of a polarity different from an adjacent region.

An annular ground electrode 101g is provided on a surface facing the electrodes 101e and 101f (Fig. 3B). At least one non-drive phase electrode provided on the same surface as the drive phase electrode 101e is electrically connected to the ground electrode 101g via a through-hole electrode 101t.

A first electrode, a second electrode, and a non-drive phase electrode that is electrically connected to the ground electrode via the through-hole electrode are formed on the same surface of a piezoelectric material, thereby the shape of a power feeding member can have a planar simple structure.

Drive phase electrodes are separated by an odd number of non-drive phase electrodes. By bonding the elastic member to the piezoelectric element, and subsequently applying a high voltage between the drive phase electrode 101e and the elastic member, polarization processing is performed on the annular piezoelectric material. Subsequently, a first electrode 101a and a second electrode 101b are provided in such a manner as to short-circuit each of two drive phase electrode groups separated by non-drive phase electrodes. The first electrode 101a and the second electrode 101b are formed at a temperature lower than a depolarization temperature of the piezoelectric material. The first electrode 101a and the second electrode 101b are used for driving of the vibration-type actuator that uses the annular piezoelectric material.

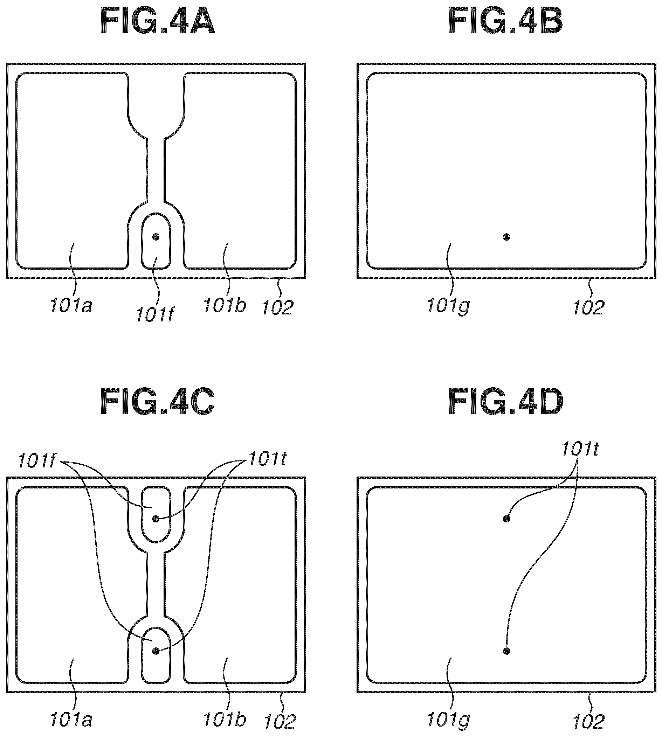

An overview of a rectangular piezoelectric element that uses a rectangular piezoelectric material will be specifically described below with reference to Figs. 4A to 4D. In Figs. 4A and 4B, one through-hole electrode is provided. The through-hole electrode is indicated by a black point in each diagram, and black points in Figs. 4A and 4B indicate top portions of the through-hole electrode 203 that appear from one opening portion and the other opening portion opposing the one opening portion of the same through-hole.

With respect to the rectangular piezoelectric element, in a case where a central line of the piezoelectric material 102 in each diagram is drawn in a traverse direction of the drawing surface, although the arrangement of the through-hole electrode is not line symmetric with respect to the central line, a manufacturing cost is low compared with a piezoelectric element including a plurality of through-hole electrodes.

On the other hand, as illustrated in Figs. 4C and 4D, in order to further improve the vibration quality of vibrational waves to be generated by a vibrating member, it is possible to employ a configuration in which through-hole electrodes are arranged substantially line symmetrically with respect to the central line. Figs. 4C and 4D illustrate a rectangular piezoelectric element in which two through-hole electrodes are provided. By providing two through-hole electrodes, the arrangement of the electrodes becomes line symmetric, and symmetry of vibrations to be produced by the piezoelectric element is enhanced.

In the rectangular piezoelectric material, the first electrode 101a, the second electrode 101b, and the non-drive phase electrode 101f are provided (Figs. 4A and 4C). The first electrode 101a and the second electrode 101b are subjected to the polarization processing with a voltage of the same polarity and are used for driving of the vibration-type actuator that uses the rectangular piezoelectric material.

The rectangular ground electrode 101g is provided on a surface facing the first electrode 101a and the second electrode 101b. At least one non-drive phase electrode 101f provided on the same surface as the drive phase electrodes 101a and 101b is electrically connected with the ground electrode 101g via the through-hole electrode 101t (Figs. 4B and 4D).

Surface electrodes to be formed on the surface of the piezoelectric material, i.e., the drive phase electrode, the non-drive phase electrode, the ground electrode, the first electrode, and the second electrode excluding the through-hole electrode, are each made of a metal film with a thickness of 0.3 to 10 $\mu$m. The material thereof is not particularly limited, but generally, silver, silver palladium, or gold is used. An electrode containing inexpensive silver as the main component is the most desirable. When the thickness of a surface electrode is less than 5 microns, the disturbance of the vibration efficiency of the piezoelectric element is suppressed, which is desirable.

(Elastic Member)

An elastic member of the present invention has conductivity, and is electrically connected with a ground electrode. Thus, when the polarization processing is performed on the piezoelectric material, the elastic member can be used as an electrode. In the case of performing the polarization processing on the annular piezoelectric material illustrated in Figs. 3A and 3B, a voltage is applied to an electrode that is not electrically connected to the ground electrode 101g of the drive phase electrode 101e and the non-drive phase electrode 101f to ground the elastic member. In the case of performing the polarization processing on the rectangular piezoelectric material illustrated in Figs. 4A to 4D, a voltage is applied to the first electrode 101a and the second electrode 101b to ground the elastic member.

Taking into consideration properties and workability as an elastic member, the elastic member 103 is desirably made of metal. As a metal that can be used in the elastic member 103, aluminum, brass, and stainless steel can be exemplified. Among stainless steels, martensitic stainless steel is desirable, and SUS420J2 is the most desirable (resistivity at room temperature is 55 $\mu\Omega$cm). The elastic member has the projection portion 106 that comes into contact with a contact member. In a case where quenching processing is performed on the elastic member with a view to improving abrasion resistance of the projection portion, by performing the quenching processing in a vacuum, it is possible to prevent formation of an oxidized film, which increases electric resistance. The SUS420J2 having been subjected to the vacuum quenching processing has high hardness and is suitable for the vibration-type actuator of the present invention that drives the contact member by friction with the elastic member.

When the thickness of the elastic member to be bonded with the rectangular piezoelectric material is in a range of 0.2 to 0.35 mm, the elastic member can have both stiffness and springiness and is easy to be molded, which are desirable.

From the viewpoint of the stiffness, the contact member 104 is desirably made of stainless steel. Among stainless steels, martensitic stainless steel is desirable, and SUS420J2 is the most desirable. Since the contact member 104 comes into frictional contact with the elastic member 103, the contact member 104 needs to have high abrasion resistance, and nitriding processing is performed on the surface. A frictional force by pressure contact acts between the projection portion 106 and the contact member 104. Due to vibration generated by the piezoelectric material 102, a tip of the projection portion 106 elliptically vibrates, and a drive force (thrust force) for driving the contact member 104 can be generated. The contact member is a member generally called a slider or rotor.

(Driving of Vibration-Type Actuator that Uses Annular Piezoelectric Material)

In the annular piezoelectric element, since adjacent piezoelectric materials in contact with the drive phase electrodes are polarized with different polarities, when an electric field of the same polarity is applied to the drive phase electrode 101e, an expansion and contraction polarity of the piezoelectric material in that region is alternately inverted with a pitch of $\lambda/2$. When an alternating voltage is applied to the first electrode 101a, a first standing wave with a wavelength $\lambda$ is generated around the entire circumference of the vibrator. When an alternating voltage is applied to the second electrode 101b, a second standing wave is similarly generated, but the position of the wave is rotationally moved by $\lambda/4$ in the circumferential direction with respect to the first standing wave. On the other hand, two types of alternating voltages with the same frequency and a temporal phase difference of $\pi/2$ are applied to the first and second electrodes. As a result of combining the first and second standing waves, a traveling wave (a wave number n along an annular ring, and a wavelength $\lambda$) of a bending vibration (a vibration with an amplitude perpendicular to the surface of the vibrator) that travels in the circumferential direction along the entire circumference is produced in the vibrator.

When the traveling wave of the bending vibration (hereinafter, sometimes simply referred to as a "bending vibration wave") is generated, each point on a surface of a vibration plate included in the vibrator performs an elliptic motion. Thus, a mobile object in contact with this surface rotates by receiving a frictional force (drive force) in the circumferential direction from the vibration plate. A rotational direction thereof can be reversed by switching positive and negative of a phase difference between the alternating voltages to be applied to the first electrode and the second electrode. In addition, a rotational speed can be controlled based on the frequency or amplitude of the alternating voltages to be applied to the first electrode and the second electrode.

(Driving of Vibration-Type Actuator that Uses Rectangular Piezoelectric Material)

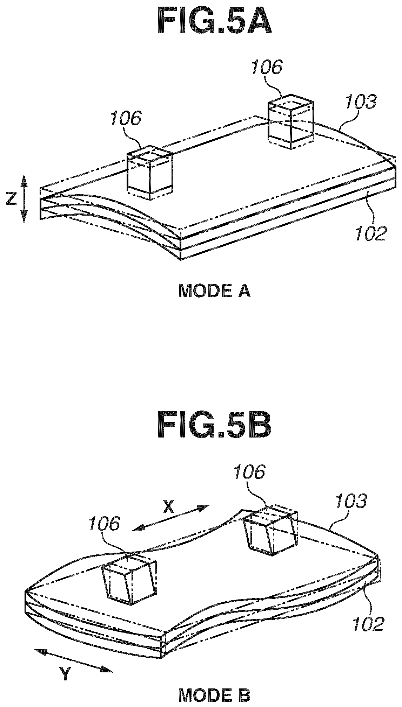

Figs. 5A and 5B illustrate two vibration modes generated by the vibrator of the present invention that includes a rectangular piezoelectric material. Regions in which the first electrode and the second electrode are provided are called a first region and a second region, respectively. The structure of the vibration-type actuator is as illustrated in Figs. 1A, 1E, and 1F.

* Mode A

When both the first region and the second region expand or contract, a first bending vibration mode (mode A) occurs. The mode A is excited most strongly when a phase difference between alternating voltages $V_A$ and $V_B$ to be applied to the first electrode 101a and the second electrode 101b is 0°, and a frequency is in the vicinity of a resonance frequency of the mode A. The mode A is a primary out-of-plane vibration mode vibration mode in which two nodes (locations where the amplitude is minimum) appear approximately parallel to a long side of the vibrator 110. Projection portions 106 of the elastic member are arranged near positions corresponding to antinodes (locations where the amplitude is maximum) of the mode A. Thus, an end face of each of the projection portions 106 is reciprocated in a Z direction by the vibration mode A.

* Mode B

When the second region contracts or expands when the first region expands or contracts, a second bending vibration mode (mode B) occurs. The mode B is excited most strongly when a phase difference between alternating voltages $V_A$ and $V_B$ to be applied to the first electrode 101a and the second electrode 101b is 180°, and a frequency is in the vicinity of a resonance frequency of the mode B. The mode B is a secondary out-of-plane vibration mode in which three nodes appear approximately parallel to a short side of the vibrator 110. The projection portions 106 of the elastic member are arranged near positions corresponding to nodes of the mode B. Thus, an end face of each of the projection portions 106 is reciprocated in an X direction by the vibration mode B.

In the vibration-type actuator 100 including a rectangular piezoelectric element, when a phase difference between the alternating voltages $V_A$ and $V_B$ is 0 to 180°, the mode A and the mode B are simultaneously excited, and elliptic vibration is excited in the projection portions 106 of the elastic member.

The vibrator is supported by a fitting hole provided in a support portion 107 protruding from an end portion of a rectangular portion 108 having a rectangular shape. With a view to downsizing the vibrator, the support portion 107 may be omitted, and the rectangular portion 108 of the elastic member can be held.

(Composition of Piezoelectric Material)

A content of lead contained in the piezoelectric material is desirably less than 1000 ppm.

In particular, from a viewpoint of a high piezoelectric constant and relatively easy manufacturing, a main component of the piezoelectric material is desirably a barium titanate-based material. Here, the barium titanate-based material includes barium titanate ($BaTiO_3$), barium calcium titanate ($(Ba, Ca)TiO_3$), barium zirconate titanate ($(Ba(Ti, Zr)O_3)$), and barium calcium titanate zirconium ($(Ba, Ca)(Ti, Zr)O_3$). The barium titanate-based material further includes compositions such as sodium niobate-barium titanate ($NaNbO_3$-$BaTiO_3$), bismuth sodium titanate-barium titanate (($Bi_{0.5}Na_{0.5}$)$TiO_3$-$BaTiO_3$), and bismuth potassium titanate-barium titanate (($Bi_{0.5}K_{0.5}$)$TiO_3$-$BaTiO_3$). Then, the piezoelectric material refers to a material containing such a composition as a main component. Among these, the following materials are desirable from the viewpoint of achieving both a piezoelectric constant and a mechanical quality factor of the piezoelectric material. More specifically, it is desirable to contain barium calcium titanate zirconium ((Ba, Ca)(Ti, Zr)$O_3$) or sodium niobate-barium titanate ((1-x)$NaNbO_3$-x$BaTiO_3$, x=0.1 to 015) as a main component. As an element other than the main component, it is desirable to contain manganese or bismuth. The main component refers to a case where a weight fraction of the material is 90% or more.

Further, it is desirable that the content of lead in the piezoelectric material be 1000 ppm or less as an environmental load is small. In general, lead zirconate titanate (Pb(Zr,Ti)$O_3$) containing lead is widely used for a piezoelectric device. Thus, it has been pointed out that there is a possibility that, for example, when a piezoelectric element is discarded and exposed to acid rain or left in a severe environment, a lead component in a conventional piezoelectric material dissolves into soil and harms an ecosystem. Thus, the piezoelectric material of the present invention is desirably a barium titanate-based piezoelectric material with a lead content of less than 1000 ppm. The lead content can be measured by, for example, ICP emission spectrometry.

The main component of the piezoelectric material is desirably barium calcium titanate zirconium (hereinafter, BCTZ). When the BCTZ is the main component, by adjusting an amount of Ca or Zr, it is possible to adjust the piezoelectricity of BCTZ depending on an intended use. It is also possible to reduce usage of expensive niobium.

It is desirable that the piezoelectric material be a piezoelectric material containing an oxide having a perovskite-type structure including Ba, Ca, Ti, and Zr, and Mn, where x denoting a molar ratio of the Ca with respect to a sum of the Ba and the Ca is $0.02 \leq x \leq 0.30$, y denoting a molar ratio of the Zr with respect to a sum of the Ti and the Zr is $0.020 \leq y \leq 0.095$ and $y \leq x$, $\alpha$ denoting a ratio between a molar quantity of the Ba and the Ca and a molar quantity of the Ti and the Zr is $0.9955 \leq \alpha \leq 1.01$, and a content of the Mn with respect to 100 parts by weight of the oxide is 0.02 parts by weight or more and 1.0 parts by weight or less in terms of metal equivalent.

Such a piezoelectric material can be represented by the following general formula (1):

$$(Ba_{1-x}Ca_x)_\alpha(Ti_{1-y}Zr_y)O_3 \qquad (1).$$

Note, however, that it is desirable that a perovskite-type metal oxide represented by the following formulas:

$$0.986 \leq \alpha \leq 1.100,$$

$$0.02 \leq x \leq 0.30,$$

and

$$0.02 \leq y \leq 0.095,$$

be a main component and that a content of a metal component other than the main component contained in the piezoelectric material be desirably 1 part by weight or less with respect to 100 parts by weight of the metal oxide in terms of metal equivalent.

In particular, Mn is contained in the metal oxide, and a content of the Mn is desirably 0.02 parts by weight or more and 0.40 parts by weight or less with respect to 100 parts by weight of the metal oxide in terms of metal equivalent. If Mn in the range is contained, an insulating property and a mechanical quality factor Qm improve. Here, the mechanical quality factor Qm is a factor indicating an elastic loss due to vibration when the piezoelectric material is evaluated as a vibrator, and the magnitude of the mechanical quality factor is observed as sharpness of a resonant curve in impedance measurement. That is, the mechanical quality factor Qm is a constant indicating sharpness of resonance of the vibrator. When the mechanical quality factor Qm is large, a strain amount of the piezoelectric material becomes larger in the vicinity of a resonance frequency, and the piezoelectric material can be effectively vibrated.

The metal oxide represented by the general formula (1) means that metal elements located at the A-site of the perovskite structure are Ba and Ca, and the metal elements located at the B-site thereof are Ti and Zr. However, some of the Ba and Ca may be located at the B-site. Similarly, some of the Ti and Zr may be located at the A-site.

The molar ratio of the elements at the B-site to the oxygen element in the general formula (1) is 1 to 3. However, even if the molar ratio slightly deviates, the metal oxide is included in the scope of the present invention as long as the metal oxide has a perovskite structure as a main phase.

Whether the metal oxide has the perovskite structure can be determined by, for example, structural analysis by X-ray diffraction or electron diffraction.

In the general formula (1), x indicating the molar ratio of Ca at the A-site is in the range of $0.02 \leq x \leq 0.30$. When some of the Ba in perovskite-type barium titanate is substituted with Ca within the range, a phase transition temperature between an orthorhombic crystal and a tetragonal crystal is shifted to the lower temperature side, and thus stable piezoelectric vibration can be obtained in a driving temperature range of the vibration-type actuator. Nevertheless, when x is larger than 0.30, a piezoelectric constant of the piezoelectric material may become insufficient, and the performance of the vibration-type actuator may become insufficient. On the other hand, when x is smaller than 0.02, dielectric loss ($\tan \delta$) may increase. When the dielectric loss increases, heat generated when the vibration-type actuator is driven by applying a voltage to the piezoelectric material may increase, motor drive efficiency may decrease, and power consumption may increase.

In the general formula (1), y indicating the molar ratio of Zr at the B-site is in the range of $0.02 \leq y \leq 0.1$. When y is larger than 0.1, Td becomes less than 80°C, which is low, and a temperature range in which the vibration-type actuator can be used becomes less than 80°C, which is undesirable.

In this specification, Td refers to the lowest temperature among temperatures at which a piezoelectric constant obtained after the piezoelectric material is heated from a room temperature to Td and cooled again to the room temperature after one week has passed since polarization processing has been performed, decreases by more than 10% compared to a piezoelectric constant obtained before heating.

Further, in the general formula (1), $\alpha$ representing a ratio of a molar quantity of the Ba and the Ca at the A-site to a molar quantity of the Ti and the Zr at the B-site is desirably in a range of $0.9955 \leq \alpha \leq 1.010$. When $\alpha$ is smaller than 0.9955, abnormal grain growth is likely to occur in crystal grains included in the piezoelectric material, and the mechanical strength of the piezoelectric material is reduced. On the other hand, when $\alpha$ is larger than 1.010, the piezoelectric material is not densified, and the insulating property becomes significantly low.

A means of measuring the composition of the piezoelectric material is not particularly limited. The means includes X-ray fluorescence analysis, ICP emission spectrometry, and atomic absorption spectrometry. Whichever of the means of measuring is used, a weight ratio and a composition ratio of elements contained in the piezoelectric material can be calculated.

The metal equivalent indicating a content of Mn involves calculating a content of each metal of Ba, Ca, Ti, Zr, and Mn measured from the piezoelectric material by X-ray fluorescence analysis (XRF), ICP emission spectrometry, atomic absorption spectrometry, and the like. From such contents, elements included in the metal oxide represented by the general formula (1) are converted into oxide equivalents. A value obtained using a ratio of the weight of MN to the total weight of the metal oxide, which is set to 100, is expressed.

When the content of Mn is less than 0.02 parts by weight, an effect of polarization processing required to drive the vibration-type actuator may become insufficient. On the other hand, when the content of Mn is larger than 0.40 parts by weight, a piezoelectric property of the piezoelectric material may become insufficient, or a crystal with a hexagonal crystal structure without a piezoelectric property may appear. The Mn is not limited to metallic Mn; it is sufficient if Mn is contained in the piezoelectric material as a Mn component, regardless of its form. For example, Mn may be dissolved at the B-site, or may be contained at a grain boundary. From a viewpoint of the insulating property and ease of sintering, Mn is more desirably dissolved at the B-site.

The piezoelectric material desirably contains Bi by 0.042 parts by weight or more and 0.850 parts by weight or less in metal equivalent.

The piezoelectric material may contain Bi in an amount of 0.85 parts by weight or less in metal equivalent with respect to 100 parts by weight of the metal oxide represented by the general formula (1). A content of Bi in the metal oxide can be measured by, for example, the ICP emission spectrometry. Bi may be present at a grain boundary of a ceramic piezoelectric material, or may be dissolved in a perovskite-type structure of $(Ba,Ca)(Ti,Zr)O_3$. When Bi is present at the grain boundary, friction between particles is reduced, and a mechanical quality factor increases. On the other hand, when Bi is taken into a solid solution forming a perovskite structure, a phase transition temperature decreases. Thus, temperature dependency of a piezoelectric constant becomes lower, and the mechanical quality factor further improves. If a position where Bi is taken into the solid solution is at the A-site, charge balance with the Mn is improved, which is desirable.

The piezoelectric material may contain a component (hereinafter, an accessory component) other than the elements included in the general formula (1), Mn, and Bi as long as the properties do not vary. The total amount of accessory components is desirably less than 1.2 parts by weight with respect to 100 parts by weight of the metal oxide represented by the general formula (1). When the accessory components exceed 1.2 parts by weight, the piezoelectric property and the insulating property of the piezoelectric material may deteriorate. A Curie temperature of $(Ba,Ca)(Ti,Zr)O_3$ is in the range of 85°C or more and 126°C or less.

The vibration-type actuator of the present invention includes a power feeding member bonded with a piezoelectric element including the piezoelectric material and the electrode.

A flexible printed circuit board (hereinafter, FPC) is desirably used as the power feeding member from a viewpoint of high dimensional accuracy and ease of positioning. As a material thereof, polyimide is desirable. A bonding method of the FPC and the piezoelectric element is not particularly limited, but it is desirable to use an anisotropic conductive paste (ACP) or an anisotropic conductive film (ACF), which has high bonding tact and high reliability of electrical connection. By feeding power by the FPC, it is possible to feed power without hindering vibration of the piezoelectric element. The FPC is connected at least to a first electrode and a second electrode, and may be connected with a non-drive phase electrode.

(Method for Manufacturing Piezoelectric Element)

A method for manufacturing the piezoelectric element will be described. First, a raw material powder of the piezoelectric material is shaped by a sheet forming method to create a green sheet with a thickness of 30 to 200 microns. Next, a position where a through-hole is formed is determined in consideration of shrinkage during firing and a cutting margin in dicing, and the through-hole is formed by punching the green sheet using a punch with a diameter of 150 microns, for example.

A paste for the through-hole electrode is printed in the through-hole. As described above, a heat-resistant material that is not to be melted during the firing process is selected as the through-hole electrode material. For example, since the above-described $(Ba,Ca)(Ti,Zr)O_3$ requires a firing temperature of at least 1300°C, a material containing platinum as a main component is used for the through-hole electrode. In the above-described $NaNbO_3$-$BaTiO_3$, because a firing temperature is 1200 to 1260°C, Ag-Pd (e.g., 0.5Ag-0.5Pd) is used for the through-hole electrode.

After the electrode is printed in the through-hole and dried, a necessary number of green sheets are laminated and pressure-bonded in consideration of shrinkage at the time of firing and a cutting margin in a lapping process. When the green sheets are laminated, positioning of the through-hole is performed so that the through-hole electrode is not disconnected in a lamination direction.

A laminated and pressure-bonded formed member is fired, and lapping processing is performed to adjust the thickness of the piezoelectric material. The protruding amount of the through-hole electrode varies depending on a lapping condition at the time. The protruding amount changes depending on the lapping condition such as a grit size (grain size) of an abrasive, a load of a workpiece, and the number of rotations of a surface plate, but depends most on the grit size. The lower the grit size, the larger the protruding amount.

After the lapping processing is performed on the piezoelectric material, printing and baking of a surface electrode are performed. The piezoelectric material provided with the surface electrode is diced into individual element pieces. For example, the dimensions of the rectangular piezoelectric element of the present invention are 9 mm × 6 mm, and a thickness is 0.3 to 0.45 mm.

(Method for Manufacturing Vibrator)

As a method for manufacturing a vibrator included in the vibration-type actuator of the present invention, the vibrator is manufactured by the following processes. First, a process of bonding a piezoelectric element and an elastic member using an adhesive agent at a temperature T1, and a process of bonding the piezoelectric element and a power feeding member at a temperature T2 are performed. Then, a process of performing the polarization processing at a temperature T3 by applying a voltage to between the electrode and the elastic member is performed, sequentially, thereby the vibrator is manufactured. The temperatures T1, T2, and T3 satisfy relationships of T1 > T3 and T2 > T3.

By using the piezoelectric element in which the through-hole electrode is protruding, it is possible to apply voltage for the polarization processing to the piezoelectric material via the elastic member while enhancing bonding strength by continuously interposing the adhesive agent between the piezoelectric element and the elastic member. By this method, even in the case of the piezoelectric material in which the depolarization temperature is lower than a bonding temperature, a vibration-type actuator can be manufactured with a high yield ratio.

(Electronic Device)

An electronic device of the present invention includes the above-described vibration-type actuator, a member connected with a contact member of the vibration-type actuator, and a member position detector (e.g., encoder). The electronic device can accurately control the position of the member by detecting the position of the member and operating the vibration-type actuator until the member reaches a targeted position.

(Optical Device)

An optical device of the present invention is an optical device including the above-described vibration-type actuator in a drive unit, and further including at least one of an optical element and an image sensor.

Figs. 5A and 5B are schematic diagrams illustrating an exemplary embodiment of an optical device (a focus lens unit of a lens barrel device) of the present invention. In Figs. 5A and 5B, the vibrator 110 including a rectangular piezoelectric material is in pressure contact with the contact member (slider) 104, similarly to Fig. 1D. A power feeding member 507 is connected to a side of a surface including first and second regions. When a desired voltage is applied to the vibrator 110 via the power feeding member 507 by a voltage input unit that is not illustrated, an elliptic motion is generated in a projection portion of an elastic member that is not illustrated. A holding member 501 is bonded with the vibrator 110 and configured not to produce unnecessary vibration. A movement casing 502 is integrated with the vibrator 110 by being fixed to the holding member 501 with a screw 503. The electronic device of the present invention is formed by these members. By attaching the movement casing 502 to a guide member 504, the electronic device of the present invention can move straight in both directions (forward direction and backward direction) along the guide member 504.

Next, a lens 506 (optical member) that serves as a focus lens of the lens barrel device will be described. The lens 506 is fixed to a lens holding member 505, and has an optical axis (not illustrated) parallel to a moving direction of the vibration-type actuator. Similar to the vibration-type actuator, the lens holding member 505 performs focus alignment (focusing operation) by moving straight on two guide members 504 to be described below. The two guide members 504 are members that enable the movement casing 502 and the lens holding member 505 to move straight by fitting the movement casing 502 and the lens holding member 505 to each other. With such a configuration, the movement casing 502 and the lens holding member 505 can move straight on the guide members 504.

A coupling member 510 is a member that transmits drive force generated by the vibration-type actuator to the lens holding member 505, and is fitted and attached to the lens holding member 505. With this configuration, the lens holding member 505 becomes movable smoothly along the two guide members 504 in both directions together with the movement casing 502.

A sensor 508 is provided to detect the position of the lens holding member 505 on the guide members 504 by reading position information of a scale 509 attached to a side surface portion of the lens holding member 505. As described above, the focus lens unit of the lens barrel device is formed by incorporating the above-described members.

In the above description, a lens barrel device for a single-lens reflex camera has been described as an optical device, but the present invention can be applied to a wide variety of optical devices including a vibration-type actuator, such as a compact camera in which a lens and a camera main body are integrated and an electronic still camera, regardless of the type of camera.

As another configuration of the vibration-type actuator, a plurality of vibrators may come into contact with one shared contact member and the contact member may be arranged to relatively move with respect to the plurality of vibrators due to vibration of the plurality of vibrators.

As an application example of the vibration-type actuator of the present invention, application to a medical field or an engineering field is considered. Specifically, it is also possible to configure a wire-driven actuator including an elongated member, a wire inserted through the elongated member and fixed to a part of the elongated member, and the above-described vibration-type actuator that drives the wire, in which the elongated member is bent by driving the wire.

Example

Next, the vibration-type actuator of the present invention will be described using examples, but the present invention is not limited by the following examples.

First, a piezoelectric element in which a through-hole electrode has a protruding portion was prepared in accordance with the above-described method for manufacturing the piezoelectric element. Table 1 indicates a relationship between a grit size of a medium used in lapping processing of the piezoelectric material and a protruding amount of a through-hole electrode.

[Table 1]

| Sample Number | Piezoelectric Material | Through-Hole Electrode Material | Medium Grit Size | Protruding Amount ($\mu$m) |
|---|---|---|---|---|
| Sample 1 | $(Ba,Ca)(Ti,Zr)O_3$ | Pt | 4000 | 1-3 |
| Sample 2 | $(Ba,Ca)(Ti,Zr)O_3$ | Pt | 2000 | 3-5 |
| Sample 3 | $(Ba,Ca)(Ti,Zr)O_3$ | Pt | 1000 | 5-10 |
| Sample 4 | $NaNbO_3-BaTiO_3$ | 5Ag-5Pd | 4000 | 1-3 |

(Example 1)

An annular shaped member of $(Ba,Ca)(Ti,Zr)O_3$ with a through-hole electrode was fired at 1340°C. An obtained sintered body was adjusted using 4000-grit silicon carbide powder so that a thickness of the piezoelectric material becomes 0.5 mm. At this time, a protruding amount of the through-hole electrode was 1 to 3 microns. In addition, the inner and outer diameters were ground to form an annular shape with an outer diameter of 62 $\times$ an inner diameter of 54 mm.

The drive phase electrode 101e and the non-drive phase electrode 101f illustrated in Fig. 3A were formed on one surface of the shaped piezoelectric material 102. In the example in Fig. 3A in which three non-drive phase electrodes are consecutively formed, the drive phase electrode 101e and the non-drive phase electrode 101f are printed so that the middle non-drive phase electrode and the through-hole are bonded. Accordingly, the installed electrode 101g illustrated in Fig. 3B is electrically connected with one of the non-drive phase electrodes 101f via the through-hole electrode 101t. A surface electrode formed by a screen printing method is dried, and then subjected to burning processing at 600 to 850°C. The thickness of the silver surface electrode after burning was 6 microns.

Next, an adhesive agent was applied to the elastic member 103 made of SUS420J2, and the elastic member 103 was pressure-bonded with the piezoelectric material 102 in which the electrode had been formed. The annular piezoelectric material and the annular elastic member were arranged in such a manner that the centers of the circles coincide with each other, using a positioning tool. Next, thermal processing for curing a conductive adhesive portion was performed. The piezoelectric material to which the elastic member had been pressure-bonded was heated to the temperature T1 = 160°C, held for 180 seconds, and then cooled to room temperature, and the elastic member and the piezoelectric element were bonded. The elastic member was electrically connected to at least one non-drive phase of the annular piezoelectric element.

Next, an FPC to which ACP was applied was thermocompression bonded to an electrode provided in the piezoelectric material. Conditions for thermocompression bonding are a temperature T2 = 140°C and a holding time of 20 seconds. Subsequently, SUS420J2 being an elastic member was grounded, and polarization processing was performed by alternately applying voltages of different polarities to the adjacent drive phase electrodes 101e. In the polarization processing, a plurality of external electrodes connected to a power source is brought into contact with the drive phase electrode 101e and an electrode not electrically connected to the installed electrode 101t and to be used as a sensor among driven phase electrodes 101f. Subsequently, after heating to T3 = 100°C, an electric field equivalent to 2kV/mm was applied for 30 minutes. Subsequently, cooling was performed to 40°C for 40 minutes while the applied electric field was maintained, and then, voltage application was ended. Subsequently, the first electrode 101a and the second electrode 101b were printed and dried to obtain a vibrator. In a drying process, to prevent depolarization of the piezoelectric material, the temperature of the piezoelectric material is held at a temperature less than 80°C. A vibration-type actuator was prepared by bringing the obtained vibrator into pressure contact with a contact member (rotor) made of SUS420J2.

(Example 2)

A plate-like shaped member of (Ba,Ca)(Ti,Zr)$O_3$ provided with a through-hole electrode was fired at 1340°C. A composition of the through-hole electrode was platinum. An obtained sintered body was adjusted using 4000-grit silicon carbide powder so that a thickness of the piezoelectric material becomes 0.4 mm. At this time, a protruding amount of the through-hole electrode was 1 to 3 microns. The first electrode 101a, the second electrode 101b, and the non-drive phase electrode 101f illustrated in Fig. 4A were printed on one surface of the plate-like piezoelectric material 102 with the adjusted thickness, and dried. Next, the installed electrode 101g was printed on an opposite surface of the piezoelectric material, and dried. A surface electrode was burned at 600 to 850°C. The thickness of the silver surface electrode after burning was 3 microns. The ground electrode 101g was electrically connected with the non-drive phase electrode 101t via the through-hole electrode 101t. Subsequently, the piezoelectric material with the surface electrode formed thereon was cut into pieces of 8.9 mm $\times$ 5.7 mm using a dicing device, and the rectangular piezoelectric element illustrated in Fig. 4A was obtained.

Next, an epoxy-based thermosetting adhesive agent was applied to the elastic member 103 illustrated in Fig. 1E that is made of SUS420J2, and the elastic member 103 was pressure-bonded to the piezoelectric material 102 in which the electrodes were formed. Next, thermal processing for curing the adhesive agent was performed. The piezoelectric material to which the elastic member had been pressure-bonded was heated to the temperature T1 = 160°C, held for 180 seconds, and then cooled to room temperature, and the elastic member and the piezoelectric element were bonded. After bonding, the elastic member was electrically connected to a non-drive phase of the rectangular piezoelectric element.

Next, an FPC to which ACP was applied was thermocompression bonded to a non-drive phase electrode provided in the piezoelectric material to prepare a vibrator. Conditions for thermocompression bonding are a temperature T2 = 140°C and a holding time of 20 seconds. Subsequently, SUS420J2 being an elastic member was grounded, and polarization processing was performed by applying a voltage of the same polarity to the first electrode 101a and the second electrode 101b. In the polarization processing, two external electrodes connected to a power source are brought into contact with the first electrode 101a and the second electrode 101b. Subsequently, after heating to T3 = 100°C, an electric field equivalent to 2kV/mm was applied for 30 minutes.

Subsequently, cooling was performed to 40°C for 40 minutes while the applied electric field was maintained, and then, voltage application was ended. A vibration-type actuator was prepared by bringing the obtained vibrator into pressure contact with a contact member (rotor) made of SUS420J2.

(Example 3)

A vibration-type actuator was prepared using the same method as Example 2 except that 2000-grit silicon carbide powder was used in lapping of a sintered body. A protruding amount of a through-hole electrode was 3 to 5 microns.

(Example 4)

A vibration-type actuator was prepared using the same method as Example 2 except that 1000-silicon carbide powder was used in the lapping of a sintered body. A protruding amount of a through-hole electrode was 5 to 10 microns.

(Example 5)

A plate-like shaped member of $0.88NaNbO_3$-$0.12BaTiO_3$ provided with a through-hole electrode was fired at 1260°C. A composition of a through-hole electrode is 5Ag-5Pd in which silver and palladium are mixed at a molar ratio of 1:1. An obtained sintered body was adjusted using 4000-grit silicon carbide powder so that a thickness of the piezoelectric material becomes 0.35 mm. At this time, a protruding amount of the through-hole electrode was 1 to 3 microns. The first electrode 101a and the second electrode 101b illustrated in Fig. 4C and the non-drive phase electrode 101f illustrated in Fig. 4D were printed on one surface of the plate-like piezoelectric material 102 with the adjusted thickness, and dried. Next, the installed electrode 101g was printed on an opposite surface of the piezoelectric material, and dried. A surface electrode was burned at 600 to 850°C. The ground electrode 101g was electrically connected with the non-drive phase electrode 101t via the through-hole electrode 101t. Subsequently, the piezoelectric material with the surface electrode formed thereon was cut into pieces of 8.5 mm × 5.7 mm using a dicing device, and the rectangular piezoelectric element illustrated in Fig. 4C was obtained.

Next, an epoxy-based thermosetting adhesive agent was applied to the elastic member 103 illustrated in Fig. 1E that is made of SUS420J2, and the elastic member 103 was pressure-bonded to the piezoelectric material 102 of $0.88NaNbO_3$-$0.12BaTiO_3$ in which the electrodes were formed. Next, thermal processing for curing the adhesive agent was performed. The piezoelectric material to which the elastic member had been pressure-bonded was heated to the temperature T1 = 160°C, held for 180 seconds, and then cooled to room temperature, and the elastic member and the piezoelectric element were bonded. After bonding, the elastic member was electrically connected to a non-drive phase 101f of the rectangular piezoelectric element.

Next, an FPC to which ACP was applied was thermocompression bonded to a non-drive phase electrode provided in the piezoelectric material to prepare a vibrator. Conditions for thermocompression bonding are a temperature T2 = 140°C and a holding time of 20 seconds. Subsequently, SUS420J2 being an elastic member was grounded, and polarization processing was performed by applying a voltage of the same polarity to the first electrode 101a and the second electrode 101b. **In** the polarization processing, two external electrodes connected to a power source are brought into contact with the first electrode 101a and the second electrode 101b. Subsequently, after heating to T3 = 150°C, an electric field equivalent to 2kV/mm was applied for 30 minutes. Subsequently, cooling was performed to 40°C for 40 minutes while the applied electric field was maintained, and then, voltage application was ended. A vibration-type actuator was prepared by bringing the obtained vibrator into pressure contact with a contact member (rotor) made of SUS420J2.

(Method for Evaluating and Manufacturing Vibration-Type Actuator, and Evaluation)

A drive test was conducted by creating five vibration-type actuators for each of Examples 2 to 4, and applying an alternating voltage with an amplitude of 120 Vpp to a first electrode and a second electrode. A phase difference in voltage between the first electrode and the second electrode at the time was -90° and 90°.

When a frequency of the alternating voltage is swept from a frequency higher than resonance frequencies of the vibration mode A and the vibration mode B toward the resonance frequencies, the contact member is driven in a direction corresponding to the phase difference of the alternating voltage, and stops after reaching the maximum speed. For the sake of convenience, traveling directions when the phase difference is -90° and 90° will be called a backward direction and a forward direction, respectively. The maximum speed of the vibrator, and a frequency at which the speed reached the maximum speed were measured using a sensor. Power (rated power) at a certain rated speed lower than the maximum speed was calculated from a current flowing in a drive circuit.

The rated power of the vibration-type actuators of Examples 2 and 3 was about 10% lower than the rated power of the vibration-type actuator of Example 4, and was substantially equal. Durability performance was evaluated by performing a continuous reciprocating movement, and the drive performance of the vibration-type actuators of Examples 2 to 4 did not significantly deteriorate after the test.

(Comparative Example 1)

A green sheet of $(Ba,Ca)(Ti,Zr)O_3$ with a thickness of about 130 microns was prepared. After a through-hole is formed in the green sheet using a punch, green sheets are laminated, pressure bonded, and fired at 1340°C without printing a through-hole electrode. An obtained sintered body was adjusted using 4000-grit silicon carbide powder so that a thickness of the piezoelectric material becomes 0.4 mm. The first electrode 101a, the second electrode 101b, and the non-drive phase electrode 101f illustrated in Fig. 4A were printed on one surface of the plate-like piezoelectric material 102 with the adjusted thickness, and dried. Next, the installed electrode 101g was printed on an opposite surface of the piezoelectric material, and dried. Through these printing processes of a surface electrode, an electrode fills a through-hole. The surface electrode and a through-hole electrode were burned at 600 to 850°C. A protruding amount of the through-hole electrode was 0 microns or less. The ground electrode 101g was electrically connected with the non-drive phase electrode 101t via the through-hole electrode 101t. Subsequently, the piezoelectric material with the surface electrode formed thereon was cut into pieces of 8.9 mm × 5.7 mm using a dicing device, and the rectangular piezoelectric element illustrated in Fig. 4A was obtained.

Next, an epoxy-based thermosetting adhesive agent was applied to the elastic member 103 illustrated in Fig. 1E that is made of SUS420J2, and the elastic member 103 was pressure-bonded to the piezoelectric material 102 in which the electrodes were formed. Next, thermal processing for curing the adhesive agent was performed. The piezoelectric material to which the elastic member had been pressure-bonded was heated to the temperature T1 = 160°C, held for 180 seconds, and then cooled to room temperature, and the elastic member and the piezoelectric element were bonded. After bonding, a vibrator in which a non-drive phase of the rectangular piezoelectric element and the elastic member are not electrically connected was included.

(Example 6)

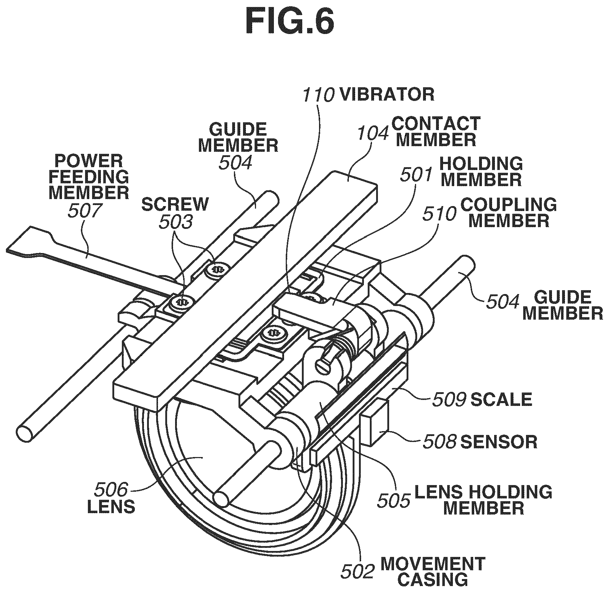

The optical device illustrated in Fig. 6 was prepared by mechanically connecting the vibration-type actuator prepared in Example 2 to an optical member. By controlling an alternating voltage to be applied to the piezoelectric material based on position information provided to an encoder including a sensor and a scale, it was possible to accurately drive the vibration-type actuator and the optical member connected with the vibration-type actuator to targeted positions. In the optical device, it was confirmed that an optical lens was connected to the vibration-type actuator, and an autofocus function was provided.

In the vibration-type actuator of the present invention that uses the piezoelectric element in which the through-hole electrode has the protruding portion, the elastic member and the ground electrode are electrically connected. Therefore, polarization failure does not occur in the process of performing polarization processing on the piezoelectric material by grounding the elastic member, and the vibration-type actuator can be manufactured with a high yield ratio.

Industrial Applicability

The vibration-type actuator of the present invention can be used for various purposes such as driving a lens or an image sensor of an imaging apparatus (optical device), rotationally driving a photosensitive drum of a copier, and driving a stage. While a single vibration-type actuator is described in the present specification, a plurality of vibration-type actuator may be annularly arranged to rotatably drive a ring-shaped contact member.

The present invention is not limited to the above-described exemplary embodiments, and various changes and modifications can be made without departing from the spirit and scope of the present invention. Accordingly, to publicize the scope of the present invention, the following claims are appended.

This application claims the benefit of Japanese Patent Application No. 2022-170049, filed October 24, 2022, which is hereby incorporated by reference herein in its entirety.

Reference Signs List

100 Vibration-type actuator
101 Electrode
101a First electrode
101b Second electrode
101e Drive phase electrode
101f Non-drive phase electrode
101g Ground electrode

101t Through-hole electrode
102 Piezoelectric material
103 Elastic member
104 Contact member
105 Conductive bonding portion
106 Projection portion
107 Support portion
108 Rectangular portion
110 Vibrator
201 Protruding portion
202 Piezoelectric material
203 Through-hole electrode
204 Ground electrode
205 Bonding layer
206 Elastic member

**Claims**

1.  A vibration-type actuator comprising:

    a vibrating member including a conductive elastic member and a piezoelectric element;
    a contact member configured to come into contact with the elastic member, the vibrating member and the contact member relatively moving due to vibration of the vibrating member,
    wherein a plate-like piezoelectric material included in the piezoelectric element has a through-hole penetrating in a thickness direction of the piezoelectric material and includes a through-hole electrode filling the through-hole,
    wherein the through-hole electrode has a protruding portion protruding from a first opening portion of the through-hole that opens on an elastic member side,
    wherein a ground electrode electrically connected to the through-hole electrode is provided on a surface on the first opening portion side of the piezoelectric material, and
    wherein the through-hole electrode and the elastic member are electrically connected.

2.  The vibration-type actuator according to Claim 1, wherein the through-hole electrode protrudes from the first opening portion of the through-hole by 10 microns or less.

3.  The vibration-type actuator according to Claim 2, wherein the ground electrode is provided between the elastic member and the through-hole electrode.

4.  The vibration-type actuator according to Claim 3, wherein non-drive phase electrodes are provided on a surface of the piezoelectric material on a side of a second opening portion opposing the first opening portion of the through-hole.

5.  The vibration-type actuator according to Claim 4, wherein the piezoelectric material is rectangular.

6.  The vibration-type actuator according to Claim 4, wherein the elastic member is rectangular.

7.  The vibration-type actuator according to Claim 4, wherein the elastic member is annular.

8.  The vibration-type actuator according to Claim 4, wherein first and second surface electrodes adjacent to the non-drive phase electrodes are provided in the piezoelectric element, and when regions in the piezoelectric material where the first electrode and the second electrode are provided are a first region and a second region, respectively, the vibrator forms a first bending vibration mode in which both the first region and the second region expand or contract, or a second bending vibration mode in which the second region contracts or expands when the first region expands or contracts.

9.  The vibration-type actuator according to Claim 4, wherein the elastic member is bonded to a surface on which the ground electrode is provided using an adhesive material, and at least one of the non-drive phase electrodes is electrically connected to the elastic member via the through-hole electrode and the ground electrode.

**10.** The vibration-type actuator according to Claim 4, wherein the elastic member is martensitic stainless.

**11.** The vibration-type actuator according to Claim 9, wherein the through-hole electrode contains platinum as a main component, and the first electrode, the second electrode, the ground electrode, and the non-drive phase electrodes contain silver as a main component.

**12.** The vibration-type actuator according to Claim 9, wherein the adhesive material is an insulating material.

**13.** The vibration-type actuator according to Claim 2, wherein a content of lead contained in the piezoelectric material is less than 1000 ppm.

**14.** The vibration-type actuator according to Claim 13, wherein the piezoelectric material contains a barium titanate-based material.

**15.** The vibration-type actuator according to Claim 14, wherein the piezoelectric material contains barium calcium titanate zirconium.

**16.** The vibration-type actuator according to Claim 4, wherein a number of through-hole electrodes provided in the piezoelectric element is one.

**17.** An electronic device comprising:

a member; and
the vibration-type actuator according to Claim 2 provided on the member.

**18.** An optical device comprising:

the vibration-type actuator according to Claim 2 in a drive unit; and
at least one of an optical element and an image sensor.

# FIG.1A

104

105    102    103

100

# FIG.1D

104

100

103    102    105

# FIG.1B

106    103

102

110

# FIG.1E

103

110

106    102

# FIG.1C

101f

102    101a

101b    101f    101e

# FIG.1F

101f    102

101a    101b

101

108    107

# FIG.2A

PROTRUDING
PORTION
*201*

PROTRUDING
AMOUNT

*202* PIEZOELECTRIC
MATERIAL

*203* THROUGH-HOLE
ELECTRODE

# FIG.2B

*205*   *206* ELASTIC
MEMBER

*204*
GROUND
ELECTRODE

*203*   *202* PIEZOELECTRIC
MATERIAL

# FIG.2C

PROTRUSION
HEIGHT

*203*

# FIG.2D

*205*

*203*

# FIG.3A

# FIG.3B

# FIG.4A

101a  101f  101b  102

# FIG.4B

101g  102

# FIG.4C

101f  101t

101a  101b  102

# FIG.4D

101t

101g  102

# FIG.5A

MODE A

# FIG.5B

MODE B

# FIG.6

110 VIBRATOR

104 CONTACT MEMBER

GUIDE MEMBER 504

501 HOLDING MEMBER

POWER FEEDING MEMBER 507

510 COUPLING MEMBER

SCREW 503

504 GUIDE MEMBER

509 SCALE

508 SENSOR

506 LENS

505 LENS HOLDING MEMBER

502 MOVEMENT CASING

## INTERNATIONAL SEARCH REPORT

| International application No. |
|---|
| **PCT/JP2023/036462** |

| A. | CLASSIFICATION OF SUBJECT MATTER |
|---|---|

*H02N 2/04*(2006.01)i; *G02B 7/04*(2021.01)i; *H10N 30/20*(2023.01)i; *H10N 30/853*(2023.01)i; *H10N 30/87*(2023.01)i
FI:     H02N2/04; G02B7/04 E; H10N30/20; H10N30/853; H10N30/87

According to International Patent Classification (IPC) or to both national classification and IPC

| B. | FIELDS SEARCHED |
|---|---|

Minimum documentation searched (classification system followed by classification symbols)

H02N2/04; G02B7/04; H10N30/20; H10N30/853; H10N30/87

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2017-184233 A (CANON KABUSHIKI KAISHA) 05 October 2017 (2017-10-05) entire text, all drawings | 1-18 |
| A | JP 2017-005794 A (CANON KABUSHIKI KAISHA) 05 January 2017 (2017-01-05) entire text, all drawings | 1-18 |
| A | JP 2017-005795 A (CANON KABUSHIKI KAISHA) 05 January 2017 (2017-01-05) entire text, all drawings | 1-18 |
| A | JP 2022-008140 A (CANON KABUSHIKI KAISHA) 13 January 2022 (2022-01-13) entire text, all drawings | 1-18 |

☐ Further documents are listed in the continuation of Box C.        ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **07 December 2023** | **26 December 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/036462**

| Patent document cited in search report | | | Publication date (day/month/year) | Patent family member(s) | | | Publication date (day/month/year) |
|---|---|---|---|---|---|---|---|
| JP | 2017-184233 | A | 05 October 2017 | US entire text, all drawings WO | 2019/0115853 2017/164413 | A1 A1 | |
| JP | 2017-005794 | A | 05 January 2017 | US entire text, all drawings CN | 2016/0359430 106253740 | A1 A | |
| JP | 2017-005795 | A | 05 January 2017 | US entire text, all drawings CN | 2016/0354167 106253739 | A1 A | |
| JP | 2022-008140 | A | 13 January 2022 | (Family: none) | | | |

Form PCT/ISA/210 (patent family annex) (January 2015)

24

**REFERENCES CITED IN THE DESCRIPTION**

**Patent documents cited in the description**

- JP 2017184233 A
- JP 2022170049 A